# EUROPEAN PATENT APPLICATION

(11) **EP 2 159 799 A1**
(43) Date of publication of application: **03.03.2010**
(21) Application number: 08163096.4
(22) Date of filing: 27.08.2008
(51) Int. Cl.: G11C 7/18, G11C 8/12, G11C 8/14

(54) **Semiconductor memory with shared global busses for reconfigurable logic device**

(71) Applicant: Panasonic Corporation, Kadoma-shi Osaka 571-8501 (JP)
(72) Inventor: Stansfield, Tony, Temple Quay, Bristol BS1 6EA (GB)
(74) Representative: Haley, Stephen

(57) **Abstract**

Memory blocks (10), such as the embedded memory blocks in a reconfigurable device, are connected together using shared global busses (35,52) and interface circuits (37). The interface circuits allow the memory blocks to he selectively connected together to form depth and width expanded memory blocks, and also allow the blocks to be used as standalone blocks. The interface circuits connect the memory array within a memory block to any desired memory input (20) and output (21) lines that are linked on the same shared global busses, to allow use of any convenient input arid output lines to access the expanded memory block. A shared global address bus (52) allows memory blocks to broadcast address information to each other, and allows unused address inputs to be re-used for broadcasting information such as block selection information or shared column information. Flexible and configurable depth and width-expanded memory blocks are thereby created.

## Description

The invention relates to semiconductor devices. More particularly, the invention relates to improvements in the memory circuits used in many semiconductor devices, including reconfigurable devices such as field programmable gate arrays (FPGAs), reconfigurable arithmetic arrays (RAAs) and other reconfigurable devices, to store and retrieve data.

Many modern reconfigurable devices have dedicated memory blocks embedded in their logic array. These memory blocks provide memory for storing data for use by the logic array. For example, when an application is configured onto a reconfigurable device, this application will often need to store data values for later use by the application or for output to other devices connected to the logic array, and/or retrieve data values previously stored, in order to perform the functions the application was designed to perform.

In most reconfigurable devices with embedded memory blocks, the memory blocks are separately wired into the logic array. These memory blocks are typically arranged in rows or columns of separate memory blocks, with each block having data and address inputs, as well as data outputs. Data is written into an address within the memory block via the data inputs, and read out of an address within the memory block via the data outputs. The address to be written to or read from is specified by the address inputs.

A conventional memory block is made up of an array of memory cells, each of which holds one bit of data (either a logic "0" or a logic "1"). These memory cells are organized as an array of rows and columns of memory cells. Each cell is located by the row the cell is in and the column the cell is in. Data is read or written in words, each of which comprise one or more bits, which typically occupy a corresponding number of cells. A word has an address, which identifies the set of cells which hold the bits that comprise the word. This address is typically expressed as a series of address bits, which in combination identify the location(s) in the array where the desired memory cell(s) is/are located.

A problem arises when an application configured onto a conventional reconfigurable device requires more memory than is available in a single memory block of the embedded memory embedded into the logic array. The embedded memory is only capable of addressing memory up to the size of one block, since the various embedded memory blocks are separate from each other. Therefore, the application designer has to configure circuitry on the logic array which associates multiple memory blocks with the application, and determines which memory addresses will be sent to each block of embedded memory associated with the application. This results in increased consumption of resources in the logic array, such as the extra logic elements which must be used for the memory management circuitry, as well as the extra load placed on the general-purpose routing network within the reconfigurable device, to route the extra signals needed to implement the memory management circuitry and communicate with the memory blocks. Therefore, a flexible and expandable memory architecture is needed which allows multiple memory blocks to be linked together in a flexible manner, to increase the effective memory available to applications without consuming valuable resources on the logic array.

In an aspect of an embodiment of the invention, a plurality of memory blocks are connected together via shared global bitlines.

In another aspect of an embodiment of the invention, a memory block is adapted to be selectively connected to or disconnected from a shared global bitline.

In another aspect of an embodiment of the invention, an interface circuit is provided to selectively connect a memory block to a shared global bitline.

In another aspect of an embodiment of the invention, a plurality of memory blocks are connected together via a shared global address bus.

In another aspect of an embodiment of the invention, a memory array within a memory block is adapted to be addressed by a shared global address bus.

In another aspect of an embodiment of the invention, a memory array within a memory block is adapted to be selectively addressed by either a local address input or a shared global address bus.

In another aspect of an embodiment of the invention, a memory block is adapted to provide an address to a shared global address bus.

In another aspect of an embodiment of the invention, a shared global address bus includes a plurality of portions, including a row address portion and a block enable portion.

In another aspect of an embodiment of the invention, a memory block is adapted to selectively drive one of a plurality of portions of a global address bus.

In another aspect of an embodiment of the invention, a plurality of memory blocks are connected together to form an expanded depth memory.

In another aspect of an embodiment of the invention, a plurality of memory blocks are connected together to form an expanded width memory.

In another aspect of an embodiment of the invention, a global address bus is adapted to selectively carry a block selection signal or a column address signal.

In another aspect of an embodiment of the invention, an unused address input is used to provide the block selection signal.

In another aspect of an embodiment of the invention, an unused address input is used to provide the column address signal.

The accompanying drawings are included to provide a further understanding of embodiments of the invention and together with the Detailed Description, serve to explain the principles of the embodiments disclosed.

FIG. 1 depicts a conventional memory block architecture.

FIG. 2A depicts an example of an arrangement of embedded memory blocks within a reconfigurable device.

FIG. 2B depicts a more detailed example of two adjacent memory blocks of the arrangement of FIG. 2A.

FIG. 3 depicts an architecture according to an embodiment of the invention, using shared global bitlines to connect two adjacent memory blocks.

FIG. 4 depicts an interface circuit and a local column circuit according to an embodiment of the invention.

FIG. 5 depicts a portion of a memory block, showing the row address input path to the memory array.

FIG. 6 depicts an architecture according to another embodiment of the invention, using a global address bus to connect two adjacent memory blocks.

FIG. 7 depicts an architecture according to another embodiment of the invention, extending the architecture of FIG. 6 to carry block selection signals.

FIG. 8 depicts an architecture according to another embodiment of the invention, extending the architecture of FIG. 6 to carry column addresses.

FIG. 9 depicts an architecture according to another embodiment of the invention, extending the architecture of FIG. 6 to carry both column addresses and block selection signals.

FIG. 10 depicts a depth and width expanded memory block, created according to an embodiment of the invention.

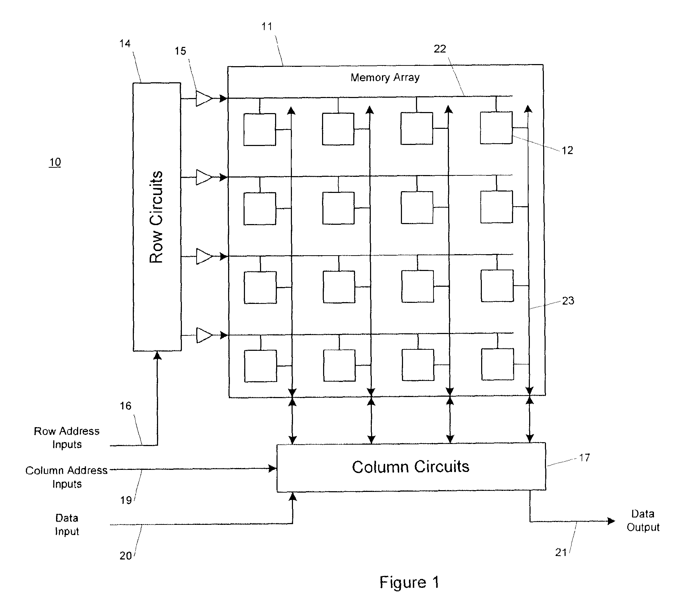

Turning to FIG. 1, a memory block 10 includes a memory array 11, memory cells 12, row circuits 14, row drivers 15, row address inputs 16, column circuits 17, , column address inputs 19, data inputs 20 and data outputs 21. The memory block 10 is an example of a conventional memory block architecture, which will be used to explain principles of embodiments of the invention. The memory array 11 includes an array of memory cells 12, organized in a rectangular arrangement of rows and columns. The memory array I 1 also includes a series of wires that connect the rows and columns of memory cells together. Each row of memory cells 12 is linked together by a wordline 22. Each column of memory cells 12 is linked together by one or more bitlines 23. The internal organization of the memory array 11 is shown in one example form, in order to better illustrate the embodiments of the invention. The specific design and/or structure of the memory array 11 are, however, not critical to the disclosed embodiments of the invention.

The memory array 11 is connected to a collection of row drivers 15. Each row driver 15 is connected to one of the wordlines 22. When a row driver 15 receives a high signal (from the row circuits 14), the row driver 15 causes the wordline 22 to go high, which activates all of the memory cells 12 in the row corresponding to the row driver 15 receiving the high signal. The row drivers 15 are connected to a collection of row circuits 14, which receive the row address data on the row address inputs 16, and decode this data to select which single one of the row drivers 15 to drive high. The row circuits 14 can use any of a variety of well-known circuits to decode the row address and activate a particular row.

The bitlines 23 are connected to a collection of column circuits 17, which receive the column address data on the column address inputs 19, and decode this data to select which bitlines 23 will send or receive data to or from the memory array 11. The column circuits 17 can also use any of a variety of well-known circuits to decode the column address and activate a particular set of columns, comprising as many columns as there are data bits in the data input 20 or data output 21.

The address inputs 16, 19 can be connected to any desired source of addresses and the data input 20 can be connected to any desired source of data to be stored in the memory. The data output 21 can be connected to any desired receiver of the output data. For example, these inputs and outputs can be connected to circuits configured onto a reconfigurable array.

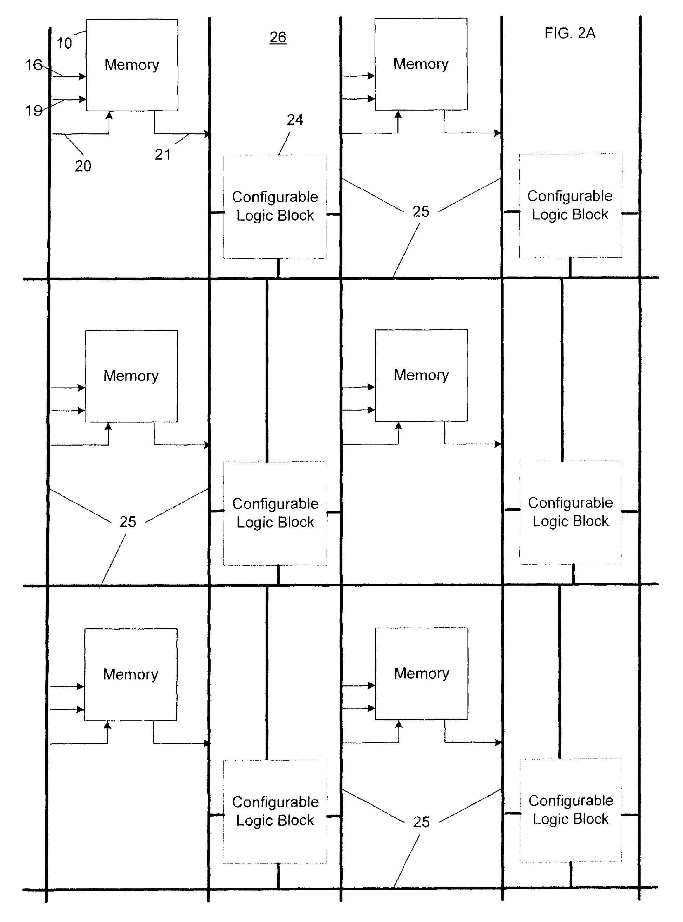

Many devices, including reconfigurable devices such as FPGAs, RAAs and the like, include embedded memory blocks, as shown in one example reconfigurable device in FIG. 2A. Fig 2A shows a portion of an example reconfigurable device 26. The reconfigurable device 26 includes embedded memory blocks 10, and configurable logic blocks 24. The configurable logic blocks 24 may include ALUs, look-up tables, multiplexers, or other logic devices used to implement an application on the reconfigurable device 26. These configurable logic blocks 24 are interconnected by a general purpose wiring network 25. This general purpose wiring network 25 links together all of the configurable logic blocks 24 and memory blocks 10, such that any of the blocks 24, 10 may be connected to any other such block. As will be discussed in further detail below, a reconfigurable device 26 according to an embodiment of the invention may be extended by use of a global address bus in addition to the general purpose wiring network, to deliver addressing information to the memory blocks 10.

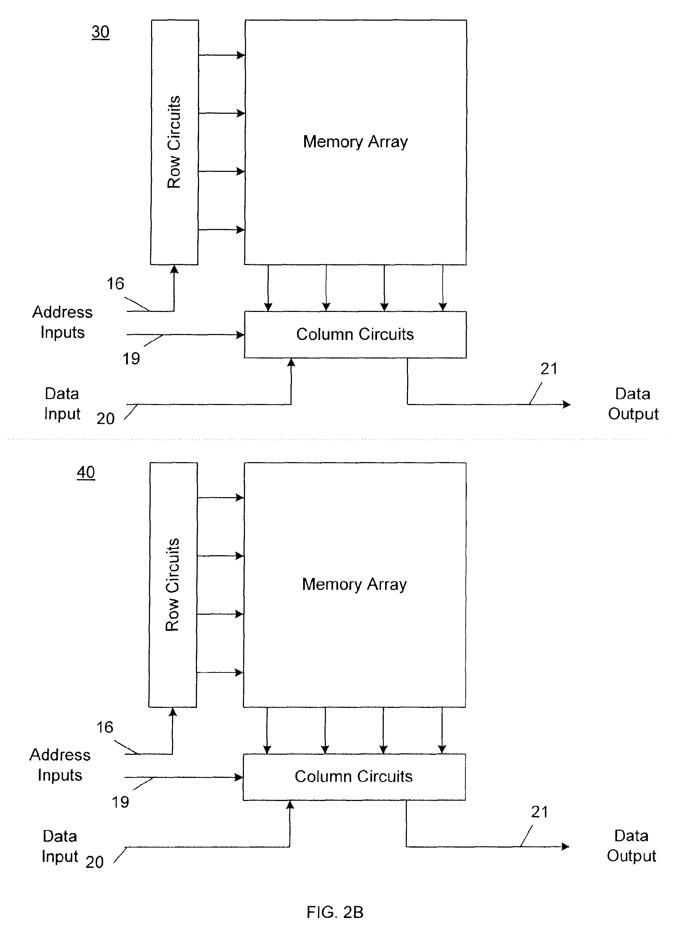

The memory blocks 10 are arranged in rows or columns, which minimizes the disruption to the regularity of the reconfigurable device, and makes it easier to both design the hardware for the device and to write the supporting software for it. Turning to FIG. 2B, a detail of two adjacent memory blocks 30, 40 in a typical reconfigurable device, arranged in columns, is shown. A first memory block 30 and a second memory block 40 are adjacent, but separate. They are each connected to a source of address inputs 16, 19, data inputs 20, and data outputs 21, which could be the same source or could be any combination of the same or different sources. For example, the memory blocks 30, 40 could both be connected by the general purpose wiring network of the reconfigurable device to a set of configurable logic elements in the reconfigurable device, which configurable logic elements are configured to implement an application on the reconfigurable device. This application could access each of the two memory blocks 30, 40 to store and retrieve information useful to the application. As noted above, the application would be responsible for performing all of the memory management tasks necessary, such as determining which memory block 30, 40 contained the desired data or was the desired destination for data to be stored. Alternatively, each memory block 30, 40 could be connected to a different set of logic elements in the reconfigurable device, wherein each set of logic elements is performing a different function or application.

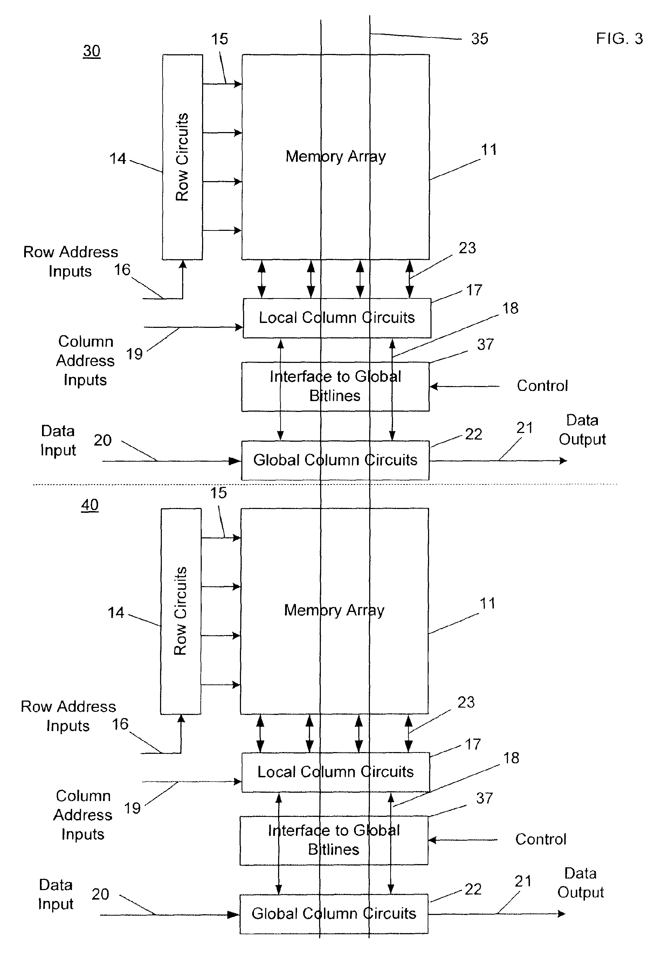

In an embodiment of the invention, as shown in FIG. 3, the two memory blocks 30, 40 are linked together by a collection of shared global bitlines 35. The shared global bitlines 35 run the length of a column of memory blocks containing the memory blocks 30, 40, as well as any arbitrary number of other blocks as desired by the designer of the reconfigurable device. Each of the shared global bitlines 35 is connected to one or more bitlines 23 of the first memory block 30 and the second memory block 40, through the local column circuits 17 of the respective memory block 30, 40, as well as to each of the other memory blocks in the column. The shared global bitlines 35 may also be connected to other circuits or devices. For example, the shared global bitlines 35 can be connected to a configuration port or programming port on the reconfigurable device, to allow the memories to be initialized with data as part of the configuration or reconfiguration of the reconfigurable device.

The shared global bitlines 35 are connected to the bitlines 23 through interface circuits 37 and local column circuits 17. The local column circuits 17 operate to multiplex the intermediate bitlines 18 to the desired bitlines 23, depending on exactly which memory cells are to be accessed. In alternative embodiments, the interface circuits 37 may be located between the local column circuits 17 and the memory array 11, or may be located between the data inputs/outputs 20, 21 and the global column circuits 22. In these two alternative embodiments, the local and global column circuits 17, 22 may be combined.

In each memory block 30, 40, the interface circuits 37 also connect via intermediate bitlines 18, to the global column circuits 22. The interface circuits 37 are adapted to selectively connect the bitlines 23 to either the shared global bitlines 35 or the global column circuits 22 (via the intermediate bitlines 18), and also to selectively connect the shared global bitlines 35 to the global column circuits 22. This allows data to be provided from the memory array 11 in any given memory block either to the global column circuits 22 within that memory block, or to the shared global bitlines 35. Once on the shared global bitlines 35, this data can then be provided to the global column circuits 22 of any other memory block connected to the shared global bitlines 35. Additionally, data can be received in the memory array 11 of a particular memory block from either the global column circuits 22 within that memory block, or from the shared global bitlines 35, which can be connected to any other memory block linked to the shared global bitlines 35.

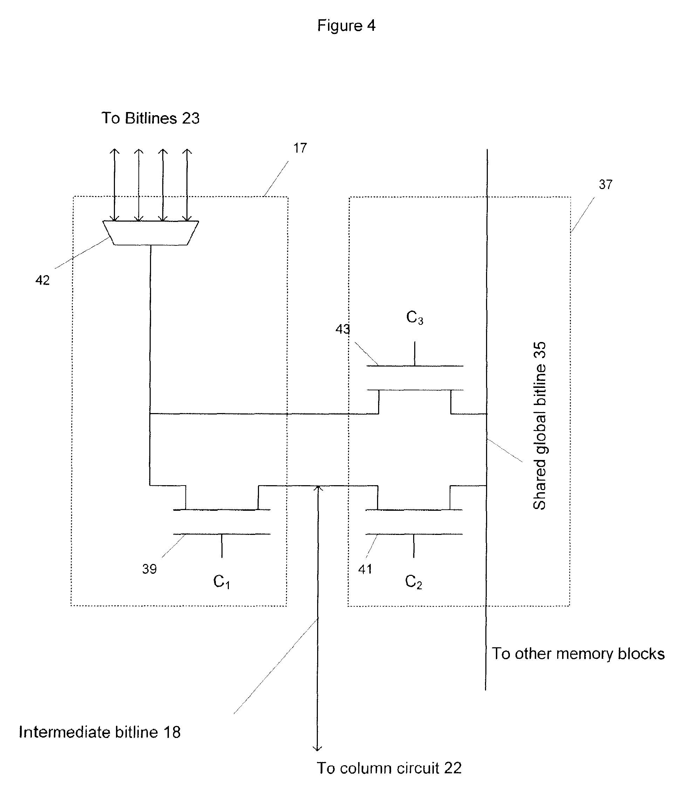

One example of an interface circuit 37 and a local column circuit 17 in accordance with an embodiment of the invention is shown in FIG. 4. The local column circuit 17 includes a multiplexer stage 42, and a first transistor 39. The interface circuit 37 includes a second transistor 41 and a third transistor 43. The interface circuit 37 is connected to the shared global bitline 35, the local column circuit 17, and an intermediate bitline 18 leading to one of the global column circuits 22. The local column circuit 17 is connected to one or more bitlines 23 of the memory array 11, and the intermediate bitline 18. The bitlines connect (via a multiplexing stage 42) to the first and third transistors 39,43. The first transistor 39 also connects to the intermediate bitline 18, and receives a control signal C₁. The third transistor 43 also connects to the shared global bitline 35, and receives a control signal C₃. The second transistor 41 is connected between the shared global bitline 35 and the intermediate bitline 18, and receives a control signal C₂. Each transistor 39, 41, 43 is turned on and allows data to pass across it when the corresponding control signal C₁, C₂, C₃ goes high (i.e. to a logic 1). Note that the multiplexer stage 42 is only required if the number of bitlines 23 in a RAM is greater than the number of global bitlines 35. If present, then the multiplexer will be controlled by a subset of the column address lines 19.

The interface circuit 37 and local column circuit 17 can operate in the following modes:

Normal block memory mode: In both memory blocks 30, 40, bitline 23 is connected from the memory array 11 to the global column circuit 22, and no connections are made to the shared global bitline 35. This corresponds to control signal C₁ being a logic 1, and control signals C₂ and C₃ being a logic 0. In this configuration, the two memory blocks 30, 40 are operating completely independently of each other, similarly to the configuration discussed above with regard to FIG. 2.

Expanded memory mode: In one or more of the memory blocks (e.g. memory block 30), the global column circuit 22 is connected to the shared global bitline 35, and not to the bitlines 23. This corresponds to control signal C₁ being a logic 0, and control signal C₂ being a logic 1. The value of control signal C₃ will be determined as part of the address decoding, as discussed in detail below (regarding the block select), to ensure that only one memory block is read from or written to simultaneously. Other memory blocks are connected only to the shared global bitlines 35, as desired, and data is routed to or from these memory blocks via the shared global bitlines 35 which are connected to the column circuits 22 in the memory block 30.

When operating in expanded memory mode, it is irrelevant which one of the column circuits 22 is connected to the shared global bitlines 35. The function of the expanded memory is the same if the column circuits 22 in the first memory block 30 are connected to the shared global bitlines 35, or if the column circuits 22 in the second memory block 40 are connected to the shared global bitlines 35. Therefore, the application designer may choose whichever data inputs 20 or data outputs 21 (connected to the column circuits 22) are most convenient for other purposes, such as being easiest to connect into the remainder of the application implemented on the reconfigurable device, and connect those inputs and outputs to the shared global bitlines 35.

Broadcast write mode: In two or more of the memory blocks (e.g. memory block 30 and 40), the bitlines 23 are connected to the shared global bitlines 35 at the same time, by setting C₁ and C₂ to a logic 0, and C₃ to a logic 1 in each such memory block. This mode allows the same input data to be broadcast to all of the memory blocks for which C₃ was turned on.

The principles discussed above can easily be extended to embodiments with more than two memory blocks. There are some additional advantages to using more than two memory blocks as well. For example, if the expanded memory concept discussed above is applied to four memory blocks in a column, the following are all possible combinations:

1. Four independent single-size memory blocks.

2. One expanded memory, four times larger than a single memory block, with four choices of data inputs and data outputs.

3. One expanded memory of two times the size of a single memory block, with two choices of data input and data output for the expanded memory, plus two independent memories.

4. One expanded memory three times larger than a single memory block, with three choices of data inputs and data outputs.

For the cases where not all of the memory blocks are used to create the expanded memory, the unused blocks are still available to be used as single-sized memory blocks. Note that the "unused" blocks (and the single-size RAMs) can be anywhere in the column. The blocks used to make the large RAM do not have to be adjacent within the column.

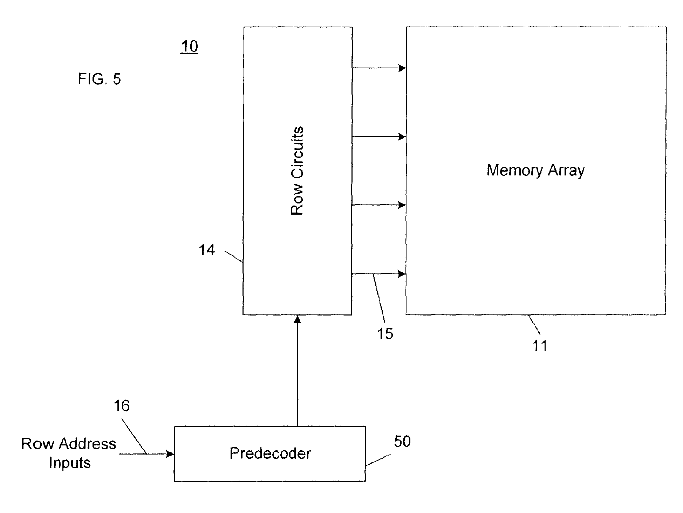

In another embodiment of the invention, a flexible address decoding scheme can be implemented using a similar approach to that described above using global bitlines. With reference to FIG. 5, in a conventional memory block 10, a row address is received on the row address inputs 16, and that row address is decoded by the row circuits 14, to identify the particular row of the memory array 11 to be activated. Optionally, the row address is predecoded by a predecoder 50, to optimize the row address for decoding by the row circuits 14.

One well-known way to predecode a row address is to combine pairs of address bits (A, B) and use these combinations to generate four predecoded output bits for each pair, corresponding to the logical functions A&B, A&(notB), (notA)&B, and (notA)&(notB). The advantage of this predecode stage is that it reduces the complexity of the row circuits 14, without increasing the number of wires that would otherwise be connected to the row circuits 14. The four signals listed above use the same number of wires as would the conventional alternative of using A, notA, B and notB as inputs to the row circuits 14.

Once the row signals have been predecoded, then the row circuits 14 decode the predecoded signals to identify the specific row that will be activated. Conventionally, the row circuits 14 each include an AND gate which provides the output to the row driver 15. This AND gate takes as inputs one of the four predecoded signals from each of the original pairs of row address bits. Each row connects to a different combination of predecoded signals.

For example, if there are 4 bits to the row address, A, B, C, D, then the first row circuit would take the first predecoded signal from each pair as inputs. The first input would be (A&B), the second input would be (C&D). Thus the first row circuit would go high when a row address of 1111 was received on the row address inputs 16. The second row circuit would take the first predecoded signal from the first pair, and the second predecoded signal from the second pair. The two inputs to the second row circuit would thusly be (A&B) and (C&notD). Thus the second row circuit would go high when a row address of 1110 was received on the row address inputs 16. The remaining rows would follow similarly, with each row going high on a specific combination of row address bits.

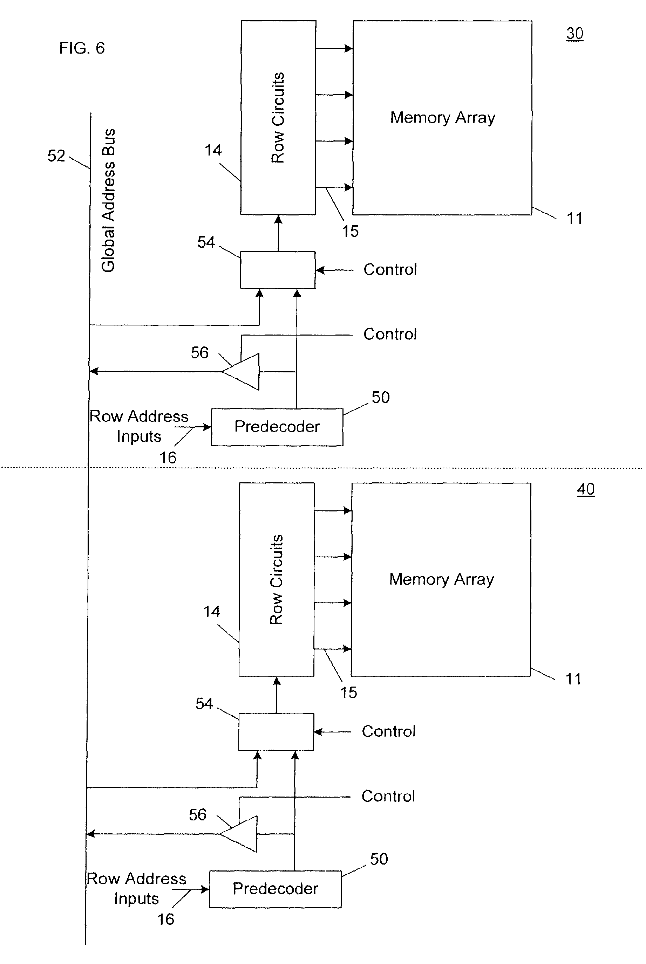

In an embodiment of the invention, shown in FIG. 6, this memory addressing scheme is extended, by adding a global address bus 52 and a select circuit 54 to each memory block 30, 40. The global address bus 52 is common to a plurality of memory blocks, such as the memory blocks 30, 40 arranged in column form in a reconfigurable device, as discussed above with reference to FIGS. 2A, 2B and 3. For each memory block 30, 40, the row circuits 14 receive the row address from the select circuit 54. The select circuit 54 is adapted to select between its two inputs, and provide the output to the row circuits 14, based on the select circuit control input. The select circuit 54 receives one input from the global address bus 52. The select circuit 54 receives a second input from the local row address inputs 16 associated with the respective memory block 30, 40, optionally predecoded by the predecoder 50. The select circuit 54 receives the control input from any desired source of control signals, such as a configuration memory, or a data line from the application implemented on the reconfigurable device. The memory array 11 within each memory block 30, 40 is therefore addressed by either the local row address input 16, or whatever signal is driving the global address bus 52. One source for driving the global address bus 52 is one of the local row address inputs 16, via a global address bus driver such as the tristate driver 56. The control input to the tristate driver 56 activates the tristate driver 56 when the global address bus 52 is to be driven by the local row address inputs 16, and deactivates the tristate driver 56 when the global row address bus 52 is to be driven by some other source. An alternate source for driving the global address bus 52 is the programming or configuration ports described above, or any other desired source of row address signals. The global address bus 52 therefore allows the row address on the local row address inputs 16 supplied to one memory block to be broadcast to other memory blocks linked by the global address bus 52. This same approach can be used to broadcast any other memory control signals desired, such as read/write control signals, or memory enable signals.

Using the global address bus 52 and the shared global bitlines 35 discussed above, in combination, allows for the expansion of the size of addressable memory, and allows for the addressing of that expanded memory. Since the amount of memory included in the expanded memory block has been increased, the size of the address required to uniquely access each memory location within the expanded memory block will increase also. For example, if each individual memory block 30, 40 requires an 8-bit address, then the two of them together would require a 9-bit address, and a group of four of them would require a 10-bit address - 8 bits to choose a location within a memory block 30, 40, and either one or two bits, respectively, to select a particular memory block.

In an expanded memory block, the row address inputs 16 are provided to one of the memory blocks 30, 40 and then broadcast to the other (receiving) memory blocks in the expanded memory block, via the global address bus 52. Therefore, the row address inputs 16 of the receiving memory blocks are not being used to provide row addresses to the memory blocks. Thus, the unused row address inputs 16 of one of the receiving memory blocks can be used to generate the block select signal. The block select signal is generated in the same manner as the row address is generated, but with fewer bits.

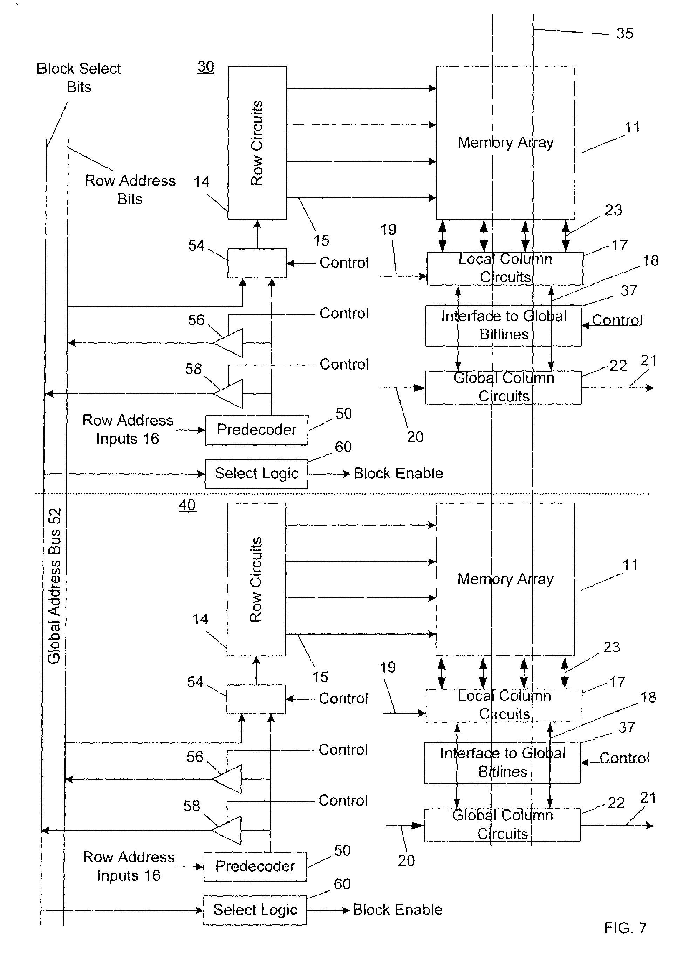

Referring to FIG. 7, the global address bus 52 is expanded to be wider than the row address provided to the row address inputs 16. This additional bus width is used to provide a block select signal, which selects a particular memory block to activate. For example, if there are four memory blocks in the expanded memory block, then the global address bus 52 could be 10 bits wide, with 8 bits used to provide the row address, and 2 bits used to provide a binary coded block select signal. Alternatively the block select signal might be pre-decoded into 4 signals each of which select one memory block, in which case the global address bus 52 would be 12 bits wide, with 8 bits used to provide the row address, and 4 bits used to provide the block select signal. This alternative is useful with the embodiment shown in FIG. 7, since the block select bits are driven from the predecoder outputs and are therefore in a 1-of-4 code. This kind of implementation has simpler select logic 60, for the same reasons that using the predecoded address simplifies the row circuits. One of the memory blocks (e.g. the memory block 30) is selected to receive the row address on the row address inputs 16 for that block, and to broadcast the row address to the other blocks (e.g. the memory block 40). One of the memory blocks receiving the row address broadcast (e.g. the memory block 40) is selected to receive the block selection bits on the row address inputs 16 for that block, and to broadcast the block select signal to the other blocks. The row address inputs 16 for memory block 40 are not being used to generate the row address, since the row address is broadcast to the memory block 40 by the memory block 30. Therefore, the row address inputs 16 (and the predecoder 50) are available to perform other functions, such as receiving and optionally predecoding the block selection bits.

Once the block selection bits are received and optionally predecoded, these bits are provided to the global address bus 52 via a global address bus driver such as the tristate driver 58. The control input to the tristate driver 58 activates the tristate driver 58 when the block selection bits are to be provided to the global address bus 52 by the corresponding local row address inputs 16, and deactivates the tristate driver 58 when the block selection bits are to be provided to the global address bus 52 by some other source. An alternate source for providing the block selection bits to the global address bus 52 is the programming or configuration ports described above, or any other desired source of block selection bits. The global address bus 52 therefore allows the block selection bits supplied to one memory block to be broadcast to other memory blocks linked by the global address bus 52.

The block selection bits are received from the global address bus 52 by the select logic 60 in each memory block 30, 40. The select logic 60 is logic that decodes the block selection bits and generates a block enable signal when the block selection bits indicate that the memory block 30, 40 has been selected. The select logic 60 is programmed beforehand with data that identifies which block selection signals should trigger an enable signal. In operation, the select logic 60 in each memory block will receive a signal from the global address bus 52 indicating which memory block should be enabled for the particular memory operation being performed. If the signal matches the pre-programmed data, then the select logic 60 generates a block enable signal.

For example, if there are four memory blocks in the expanded memory block, and thus two bits in the block selection signal, then there are four possible combinations of block selection bits: "00", "01", "10", and "11", each of which corresponds to a different memory block within the expanded memory block. The select logic 60 in each block will be programmed to respond to one of these signals. Thus, for example, the select logic 60 in memory block 30 will respond to "00", and the select logic in memory block 40 will respond to "01". Other memory blocks will respond to "10" and "11" respectively. When the selection logic 60 in memory block 30 receives a "00" block selection signal, it will generate a block enable signal for the memory block 30. When the selection logic 60 in memory block 30 receives any other block selection signal, it will not generate the block enable signal. This block enable signal enables the block, and allows data to be written to or read from the block. For example, the block enable signal is provided as the control signal C3 to the interface circuit 37 of FIG. 4. The memory block which is enabled by the block enable signal can also be connected to the shared global bitlines, as shown in FIG. 7 and as discussed above. Thus the enabled block can read data from or write data to the shared global bitlines 35 or to the data inputs/outputs 21, 21 of the enabled block.

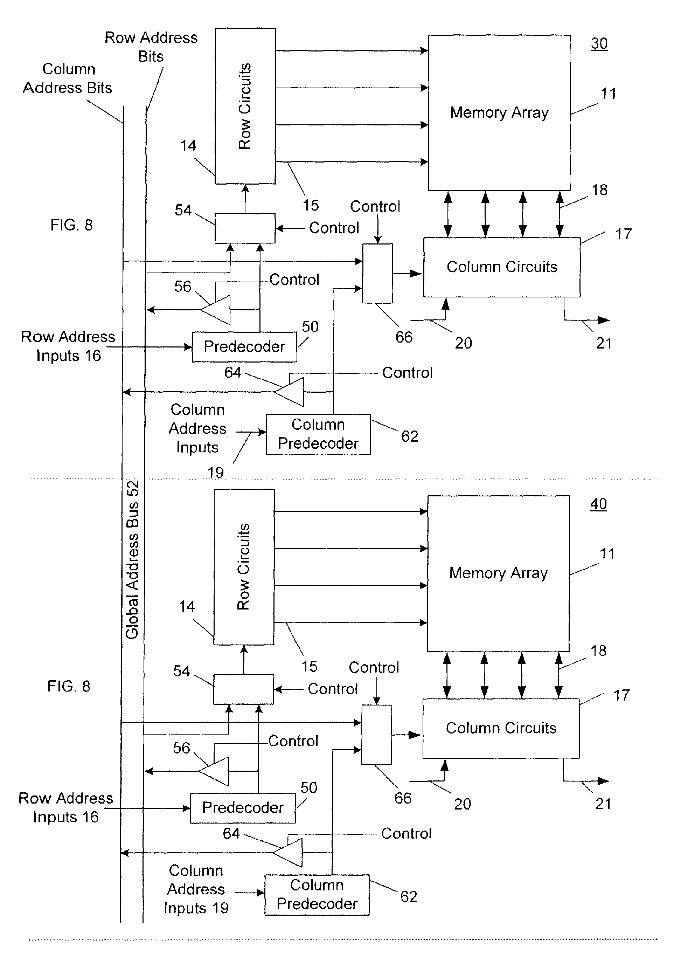

In addition to expanding the available depth of memory by joining memory blocks together to form an expanded memory block, it is also possible to expand the available width of memory using similar concepts. In the width-expansion mode, with reference to FIG. 8, the global address bus 52 is used to broadcast the row address provided on the row address inputs 16 of one memory block to the other memory blocks, as described above, but the shared global bitlines 35 are not used. Each memory block uses its own data inputs 20 and data outputs 21 to receive and transmit data into and out of the memory block. The result of this mode is a memory having the standard address width, but increased data width. For example, if the memory block 30 and the memory block 40 are each driven by the same row address inputs 16, then each memory block 30, 40 will output the data stored in the same row within the respective memory blocks. Thus if each block were 4 bits wide, then when combined the blocks would output an 8-bit value. The row address width, however, would remain the same.

In order to increase the width of the expanded memory block in this manner, the column address provided on the column address inputs 19 is shared by the column circuits 17 of each memory block 30, 40. This can be implemented by widening the global address bus 52 to carry the column address, in a manner similar to that discussed above for the block selection bits. In an embodiment, the same wires that carry the block selection signals can also be used to carry the column address. When the memory blocks 30, 40 are combined to create a depth-expanded memory block, the additional wires on the global address bus 52 carry the block selection signals used to expand the depth of the expanded memory block. When the memory blocks 30, 40 are combined to create a width-expanded memory block, then the additional wires on the global address bus 52 carry the column address used to expand the width of the expanded memory block. In an alternate embodiment, the global address bus 52 is widened sufficiently to carry both the block enable and column address signals simultaneously.

In the operation of a memory block (e.g. the memory block 30) of the circuit of FIG. 8, the column address is received on the column address inputs 19, and optionally provided to a column predecoder 62 for predecoding. The column address is then provided to a select circuit 66, and to a global address bus driver such as the tristate driver 64. The tristate driver 64 is activated (by the control input) when the memory block 30 is configured to broadcast the column address to other blocks in the expanded memory block. The select circuit 66 is configured to propagate either the column address from the column address inputs 19, or the column address from the global address bus 52, depending on a control signal. If the memory block is part of a width-expanded memory block, then the column address is obtained from the global address bus 52. If the memory block is a standalone block, then the column address is obtained from the column address inputs 19. The column address is then provided to the column circuits 17, as described above, where the column address is used to identify the column to read or write data to or from, via the data inputs 20 and data outputs 21.

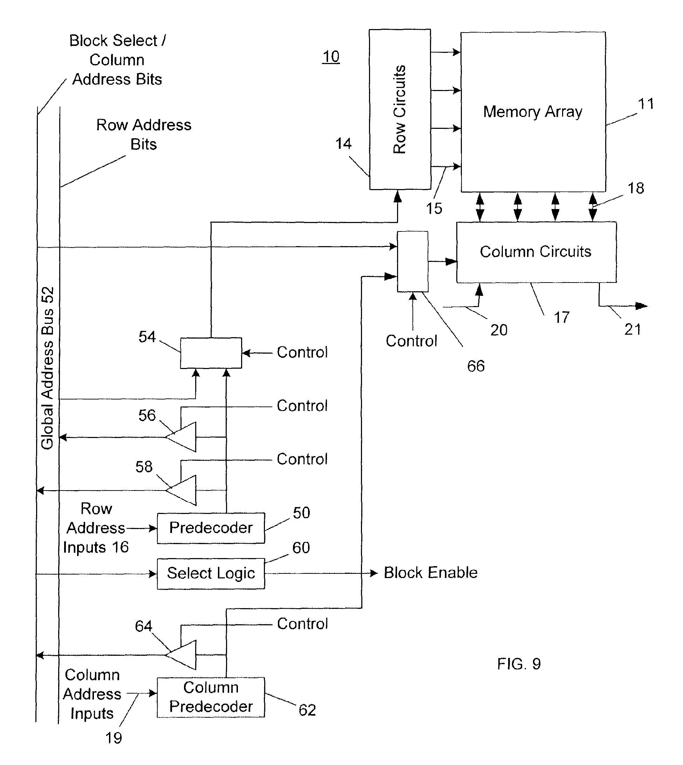

The depth-expansion and width-expansion circuits discussed above can be combined to create a collection of memory blocks which can form either depth-expanded or width-expanded memory blocks, as shown in FIG. 9. The elements in FIG. 9 are connected in the same manner as the corresponding elements in FIGS 7-8. The global address bus 52 may be further widened to accommodate the simultaneous sending of the block selection signal and the column address signal. Amongst other possible alternative embodiments, one of the signals can be temporarily buffered, such that both signals are available as needed by the memory block 10.

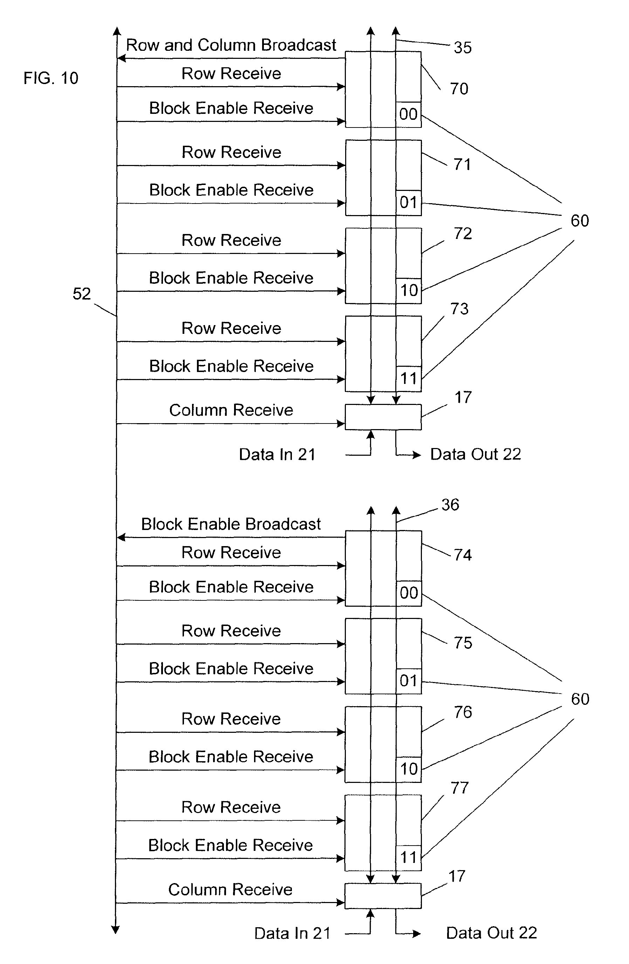

Additionally, an expanded memory can be created that allows for both depth-expansion and width-expansion at the same time. For example, turning to FIG. 10, an expanded memory block can be created using eight memory blocks, that is four blocks deep and two blocks wide. Memory blocks 70-73 are serviced by global bitlines 35, and memory blocks 74-77 are services by global bitlines 36, which are separate from global bitlines 35. The select logic 60 in each block is pre-programmed to identify which block selection bit values each memory block will respond to. Memory blocks 70, 74 comprise block "00"; memory blocks 71, 75 comprise block "0 1 "; memory blocks 72, 76 comprise block "10"; memory blocks 73, 77 comprise block "11". One of the memory blocks (e.g. block 70) broadcasts the row and column addresses to the other blocks. A second memory block (e.g. block 74) broadcasts the block number to the other blocks. When a memory operation is performed by an application, the application provides the row address, column address and block number for the memory location to be accessed. The row address is received by block 70 and broadcast to the other blocks. The column address is also received by block 70 and broadcast to the other blocks. The block number is received by the block 74 and broadcast to the other blocks. Note that the global address bus 52 may be widened to accommodate the simultaneous broadcast of the block number and the column address, or the block number and column address may be broadcast in series, possibly using a buffer for each memory block, to temporarily store one of the broadcast values. The broadcast addresses operate to identify the two memory locations in the memory blocks belonging to the block corresponding to the broadcast block number, and in the row and column corresponding to the broadcast row and column addresses.

For example, assuming that each memory block 70-77 is four bits deep by four bits wide, an application would provide an address such as "011100" as the address containing the memory location to be accessed. The first two bits identify the desired block "01", the next two bits identify the desired row "11" and the final two bits identify the desired column "00". The block identification bits are provided on the unused row inputs to memory block 74, and broadcast over the global address bus 52 to the other memory blocks. The select circuits 60 in each of the memory blocks 70-77 read the block identification bits, and the select circuits 60 in memory blocks 71 and 75 (corresponding to the pre-programmed block identifier of "0 1") enable memory blocks 71 and 75. The remaining memory blocks are not enabled. The row address "11" and column address "00" are received by memory block 70, and broadcast to the other blocks. Each of the memory blocks 70-77 receives the row address and activates the row in the memory block (row "11" in this example). Each memory block 70-77 also receives the column address, but since as discussed above, any one of the column circuits 17 may be connected to the global bitlines 35, 36 running through each column of memory blocks, only one column circuit 17 is depicted in the figure for each column, for simplicity. Since only blocks 71 and 75 are enabled, only those blocks are connected to the two sets of global bitlines 35, 36. Therefore, the column circuit 17 for each column accesses the memory cell located at column "00" of the enabled memory blocks 71 and 75. If the memory operation is a read, then the values at the selected location ("1100" of memory blocks 71 and 75 are read out on the respective data outputs for each of the two columns via the two respective sets of global bitlines 35, 36. If the memory operation is a write, then the values on the respective data inputs for each of the two columns are written to the selected location ("1100") of the memory blocks 71 and 75 via the two respective sets of global bitlines 35, 36.

In the foregoing specification, the invention has been described with reference to specific embodiments thereof. It will, however, be evident that various modifications and changes may be made thereto without departing from the broader spirit and scope of the invention. For example, the reader is to understand that the specific composition and combination of components shown in the circuit diagrams described herein is merely illustrative, and the invention can be performed using different or additional components, or a different combination or composition of components. The memory blocks have been discussed herein as being components of a reconfigurable device. In alternative embodiments, the memory blocks can be components of any other circuit or device where it is desired to selectively connect memory blocks together to expand the depth or width of available memory. The specification and drawings are, accordingly, to be regarded in an illustrative rather than restrictive sense, and the invention is not to be restricted or limited except in accordance with the following claims and their legal equivalents.

## Claims

1. A memory circuit comprising:
a first memory block comprising;
a first memory array comprising a first plurality of memory cells adapted to contain memory data,
a first column access circuit connected to the first memory array, the first column access circuit comprising;
a first plurality of interface circuits and a first plurality of column circuits, each column circuit connected to one of the first plurality of interface circuits,
a first column address input connected to the first column access circuit;
a first memory data input connected to the first column access circuit, and
a first memory data output connected to the first column access circuit;
a second memory block comprising;
a second memory array comprising a second plurality of memory cells adapted to contain memory data,
a second column access circuit connected to the second memory array, the second column access circuit comprising;
a second plurality of interface circuits and a second plurality of column circuits,
each column circuit connected to one of the second plurality of interface circuits,
a second column address input connected to the second column access circuit;
a second memory data input connected to the second column access circuit, and
a second memory data output connected to the second column access circuit;
and
a shared global bitline connecting one of the first plurality of interface circuits with one of the second plurality of interface circuits.

2. The memory circuit of claim 1, wherein the first plurality of interface circuits are adapted to selectively connect the first memory array to either the first plurality of column circuits or the second plurality of column circuits, depending on a control signal on a control input for the first plurality of interface circuits.

3. The memory circuit of claim 2, wherein the first memory array is adapted to be connected to the second plurality of column circuits via the first plurality of interface circuits, the shared global bitline, and the second plurality of interface circuits.

4. The memory circuit of claim 1, wherein the first plurality of interface circuits are adapted to selectively connect the first memory array to either the first column address input or the second column address input, depending on a control signal on a control input for the first plurality of interface circuits.

5. The memory circuit of claim 1, wherein the first plurality of interface circuits are adapted to selectively connect the first memory array to either the first plurality of column circuits or the shared global bitline, depending on a control signal on a control input for the first plurality of interface circuits.

6. The memory circuit of claim 5, wherein the first plurality of interface circuits each comprise a first interface gate connected between the memory array and one of the first plurality of column input circuits, a second interface gate connected between the one of the first plurality of column input circuits and the shared global bitline, and a third interface gate connected between the memory array and the shared global bitline, wherein each interface gate is adapted to be activated by a respective control signal, and wherein the respective control signals in combination perform the selective connect.

7. The memory circuit of claim 5, wherein the second memory block is useable as a standalone memory block when the second memory block is not connected to the first memory block.

8. The memory circuit of claim 1, wherein the first and second memory blocks are adapted to be combined into an expanded memory block by linking the first memory block and the second memory block together using the shared global bitline.

9. The memory circuit of claim 1, wherein the shared global bitline is one of a plurality of shared global bitlines, and wherein there is one shared global bitline and one interface circuit for each of a plurality of columns of memory cells in the first memory array.

10. A reconfigurable device comprising:
a plurality of configurable logic blocks,
a general purpose wiring network connected to the plurality of configurable logic blocks; and
a memory circuit, the memory circuit comprising:
a global address bus, separate from the general purpose wiring network, for receiving a row address, and
a first memory block comprising;
a memory array comprising a plurality of memory cells adapted to contain memory data,
a plurality of row circuits connected to the memory array, for decoding the row address,
a local row address input, connected to the general purpose wiring network, for receiving the row address, and
a row address selector for selecting between the row address input and the global address bus for providing the row address to the row circuits.

11. The reconfigurable device of claim 10, further comprising a global address bus driver for supplying the row address from the row address input to the global address bus.

12. The reconfigurable device of claim 11, wherein the global address bus driver is controllable to provide the row address from the row address input to the global address buffer when the first memory block is configured to broadcast the row address to a second memory block.

13. The reconfigurable device of claim 10, wherein the global address bus is adapted to be connected to a second memory block.

14. The reconfigurable device of claim 10, wherein the global address bus is adapted to be connected to a configuration input.

15. The reconfigurable device of claim 10, wherein the row address selector is adapted to select the global address bus when the first memory block is configured to receive the row address from a second memory block.

16. The reconfigurable device of claim 10, wherein the row address selector is adapted to select the row address input when the first memory block is configured to broadcast the row address to a second memory block.

17. The reconfigurable device of claim 10, further comprising select logic for receiving a block selection signal from the global address bus and receiving pre-programmed data defining a block identifier, wherein the select logic generates a block enable signal if the block selection signal matches the pre-programmed data.

18. The reconfigurable device of claim 10, further comprising a global address bus driver, adapted to supply a block selection signal to the global address bus from the row address input when the first memory block is configured to broadcast the block selection signal.

19. The reconfigurable device of claim 10, wherein the global address bus is adapted to carry both the row address and a block selection signal.

20. The reconfigurable device of claim 10, wherein the global address bus receives a column address and the memory circuit further comprises:
a plurality of column circuits connected to the memory array for decoding the column address,
a column address input for receiving the column address, and
a column address selector for selecting between the column address input and the global address bus for providing the column address to the column circuits.

21. The reconfigurable device of claim 20, further comprising a global address bus driver for supplying the column address from the column address input to the global address bus.

22. The reconfigurable device of claim 21, wherein the global address bus driver is controllable to provide the column address from the column address input to the global address bus when the first memory block is configured to broadcast the column address to a second memory block.

23. The reconfigurable device of claim 20, wherein the column address selector is adapted to select the global address bus when the first memory block is configured to receive the column address from a second memory block.

24. The reconfigurable device of claim 20, wherein the column address selector is adapted to select the column address input when the first memory block is configured to broadcast the column address to a second memory block.

25. The reconfigurable device of claim 20, wherein the global address bus comprises a first portion for receiving the row address, and a second portion for receiving the column address and the block selection signal.
